# EUROPEAN PATENT APPLICATION

(11) **EP 4 387 103 A1**
(43) Date of publication of application: **19.06.2024**
(21) Application number: 22213290.4
(22) Date of filing: 13.12.2022
(51) Int. Cl.: H03L 7/087, G01R 19/00, H03L 7/099

(54) **PHASE LOCKED LOOP**

(71) Applicant: Shanghai DN Semiconductors Co., Ltd., Shanghai (CN)
(72) Inventor: van Dongen, Marijn, Utrecht (NL); de Nie, Robert, Culemborg (NL)
(74) Representative: Müller-Boré & Partner Patentanwälte PartG mbB

(57) **Abstract**

The disclosure relates to a phase locked loop, comprising: a hybrid-controlled oscillator (108), a sync pulse detector (104), a phase locked loop controller (106) and a phase pulse controller (101). The hybrid-controlled oscillator (108) comprises a digital control input and an analog control input, wherein a frequency of oscillation of an oscillator signal (128) from the oscillator (108) is responsive to both the digital control input and the analog control input. The sync pulse detector (104) is configured to receive an input signal (122) and to output a sync pulse signal (124) that is synchronised to the input signal (122) and a phase pulse enable signal (125) that is synchronised with the oscillator signal (128). The phase locked loop controller (106) is configured to receive the sync pulse signal (124) and the oscillator signal (128) and to provide a digital control signal (127, 126) at the digital control input of the hybrid-controlled oscillator (108) responsive to an error between the sync pulse signal and the oscillator signal. The phase pulse controller (101) is configured to receive the phase pulse enable signal (125) and the input signal (122), and to output an analog phase control signal (123) to the hybrid-controlled oscillator (108) corresponding with a timing error between the phase pulse enable signal (125) and the input signal (122).

## Description

### Field

The disclosure relates to a phase locked loop, which is particularly applicable to synchronised daisy chained devices.

### Background

In some systems, daisy chained devices may be required to communicate with each other and/or with an external device such as a controller. Examples of such systems are found in battery management, in which a cell controller circuit may be provided for each cell of a battery pack. Each cell controller may be required to receive commands and return management data to a battery-pack controller. Such a battery system may comprise more than 50 daisy chained devices. Battery systems with 250 cell controllers connected in series are possible.

In order to facilitate communication via daisy chained devices, the internal clock of each device must be locked to the incoming data (and hence the clock of the preceding integrated circuit). There are two main reasons why this locking is important.

The frequency of the oscillator should be locked to ensure stable communication. If, for example, the frequency of the previous device is higher it means that the device will receive data faster than it is sending out to the next device. This may eventually result in internal buffer overflow and data will be lost. If the clock frequency of the previous device is lower, the data will not come in fast enough and eventually the device will run out of data to send to the next device.

It is desirable for the phase of the oscillator to be locked to avoid interference effects. A specific example is impedance measurements in battery management systems. During impedance measurement, the IC will create an excitation signal of considerable amplitude (up to several hundreds of mA), while it measures a very low amplitude signal (several hundreds of µV). Since the excitation currents of one battery are flowing close to the sensitive sense wires of the neighbouring cells, the excitation currents will disturb the measurement. As long as the disturbance is constant, it can be compensated for. However, if the clock phase of the ICs is not constant, the interference component will continuously shift, causing a large noise component in the measurement.

### Summary

According to a first aspect there is provided a phase locked loop, comprising:
a hybrid-controlled oscillator, comprising a digital control input and a phase pulse control input, wherein a frequency of oscillation of an oscillator signal from the oscillator is responsive to both the digital control input and the phase pulse control input;
a sync pulse detector configured to receive a digital input signal and to output a sync pulse signal that is synchronised to the input signal and a phase pulse enable signal that is synchronised with the oscillator signal;
a phase locked loop controller configured to receive the sync pulse signal and the oscillator signal, and to provide a digital control signal at the digital control input of the hybrid-controlled oscillator responsive to an error between the sync pulse signal and the oscillator signal;
a phase pulse controller, configured to receive the phase pulse enable signal and the input signal, and to output a phase control signal to the hybrid-controlled oscillator corresponding with a timing error between the phase pulse enable signal and the input signal.

The digital input signal may be a communications signal that encodes a clock signal. The digital input signal may, for example, be communication signal that is Manchester encoded. The phase control signal may be unquantized in the time domain (i.e. asynchronous with the oscillator signal).

The phase pulse controller may be configured to generate a phase control signal that:
i) is enabled by the phase pulse enable signal; and
ii) switches state in response to an edge of the input signal.

The phase pulse controller may be configured to produce a phase control signal that:
i) comprises a positive current when the phase control signal is enabled and in a first state, and
ii) comprises a negative current when the phase control signal is enabled and in a second state.

The phase locked loop may comprise a low pass filter configured to filter the phase control signal.

The hybrid-controlled oscillator may comprise a digitally controlled current source that is responsive to the digital control input, wherein the low pass filter filters the sum of the output current from the digitally controlled current source and the phase control signal.

The sync pulse detector may further comprise a randomiser, configured to pseudo-randomly enable or disable the phase control signal (e.g., at each cycle of the phase pulse enable signal), thereby shaping phase noise of the oscillator output.

The sync pulse detector may be configured to produce a periodic phase pulse enable signal that is in a first state (e.g., high) for one clock period of the input signal and in a second state (e.g., low) at other times.

The sync pulse detector may be configured to produce a phase pulse enable signal with a frequency corresponding with a symbol rate of the input signal.

The hybrid controller oscillator may comprise a relaxation oscillator configured to switch between charging and discharging one or more core capacitors to generate the oscillator signal.

According to a second aspect, there is provided a plurality of devices, each device comprising a phase locked loop according to the first aspect (including optional features thereof). The plurality of devices is connected in series. The phase locked loop of each device subsequent to a first device is configured to synchronise with an output signal from a preceding device.

According to a third aspect, there is provided a battery monitoring circuit, comprising a phase locked loop according to the first aspect (including any optional features thereof).

Each device of the second aspect may be a battery monitoring circuit.

The battery monitoring circuit of the first aspect may further comprise a cell impedance test circuit configured to test a cell impedance of one or more associated cells, wherein the battery monitoring circuit is configured to perform the cell impedance test synchronously with the input signal. In the plurality of battery monitoring circuits of the second aspect, each battery monitoring circuit may comprise a cell impedance test circuit configured to test a cell impedance of one or more associated cells, wherein each battery monitoring circuit is configured to perform the cell impedance test synchronously with its input signal.

According to a fourth aspect, there is provided a method of synchronising a device to a digital input signal, comprising:
producing a phase pulse enable signal that is synchronised with an oscillator of the device,
producing a phase control signal corresponding with a timing error between the phase pulse enable signal and the input signal.

The phase control signal may be:
i) enabled by the phase pulse enable signal; and
ii) switch state in response to an edge of the input signal.

The method of the fourth aspect may include steps that are described with reference to the first to third aspect, or that are described below in relation to the specific embodiments.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic diagram of a battery management system comprising a chain of battery monitoring circuits;
Figure 2 depicts battery impedance measurement in adjacent batteries;
Figure 3 is a block diagram of a phase locked loop;
Figure 4 shows phase error from a single instance of the phase locked loop according to Figure 3;
Figures 5 and 6 show phase error and phase noise in a chain on phase locked loops according to Figure 3, illustrating a build-up of phase error and consequent phase noise;
Figure 7 is a block diagram of a phase locked loop according to an embodiment;
Figure 8 illustrates an example analog phase control scheme;
Figure 9 is a circuit diagram illustrating an example hybrid-controlled oscillator and an analog controller;
Figures 10, 11 and 12 show phase stability and phase noise results for an example embodiment respectively having a low, medium and high current for the analog control signal;
Figures 13, 14, and 15 shows phase stability and phase noise results for an example embodiment respectively having a low, medium and high current for the analog control signal in which analog control is pseudo randomly enabled for noise shaping; and
Figures 16 and 17 show a relationship between ADC noise in a battery monitoring circuit and current level for an analog control signal for always enabled control and pseudorandom enabling.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

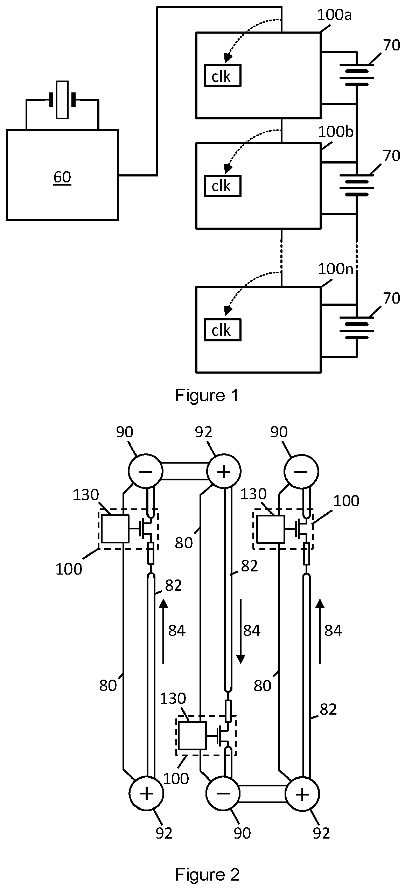

Referring to Figure 1 a battery management system is depicted schematically, comprising a battery pack controller 60, and battery monitoring circuits 100a-n. Each battery monitoring circuit 100a-n is connected to one or more cells 70 and is responsible for monitoring health and/or performance thereof. Each battery monitoring circuit 100a-n may, for example, comprise a battery impedance measurement circuit that is configured to measure an internal impedance of the one or more associated cells 70. The battery pack controller 60 may be configured to transmit commands to, and to receive measurement data from, the battery monitoring cells 100a-n. In order to facilitate this, data must be communicated between the battery pack controller 60 and the battery monitoring circuits 100a-n. A communication signal from the pack controller 60 may be received by the first battery monitoring circuit 100a, and the clock clk, of the battery monitoring circuit 100a may be synchronised with the received signal (e.g., using a phase locked loop arrangement). The first battery monitoring circuit 100a outputs a communication signal, which is in turn received by the second battery monitoring circuit 100b, which in turn comprises a clock that is synchronised to the communications signal input thereto. This chain may continue over tens (or even hundreds) of battery monitoring circuits (for example in a large battery pack such as a battery electric vehicle battery pack). As outlined in the background, it may be important to ensure that the clock of each battery monitoring circuit is properly phase locked to each of the other battery monitoring circuits 100a-n and optionally to the pack controller 60. In some embodiments, frequency lock with the pack controller 60 may be sufficient.

Figure 2 shows an example of adjacent battery monitoring circuits 100, configured to measure the impedance of cells. Each battery monitoring circuit 100 comprises an integrated circuit 130 controlling an external transistor and resistor in order to excite a current through the one or more cell connected between terminals 90, 92. In some embodiments the external transistor and resistor may be integrated with the integrated circuit 130. The voltage resulting between the positive and negative terminal 92, 90 can be measured via tracks 80 by the integrated circuit 130 and the impedance of the one or more cells inferred from the ratio of the voltage and current. Since adjacent cells may be close together, the excitation currents 84 through neighbouring cells may cause interference in nearby measurements. The excitation signal may be relatively large (for example up to several hundreds of mA), and the resulting voltage over the cell may be relatively small (e.g., several hundreds of µV). If the timing of the disturbance is well controlled, it can be compensated for in the measurement. If the clock phases of adjacent battery monitoring circuits 100 are not well matched, the interference component will shift, causing significant noise in the impedance measurement.

In general, in order to match the timing of the clock circuits in chained devices of this type, it is necessary to implement a phase locked loop in each device. It may be desirable for the phase locked loop to:
i) have a sufficiently slow control loop (low cut-off frequency) to avoid interference in one battery monitoring circuit from propagating through the chain;
ii) not create significant additional jitter in the oscillator, because the impedance measurement ADC (measuring the voltage resulting from the excitation current) may be sensitive to jitter (for example, in the case where the ADC has a continuous time implementation). The accuracy of the impedance measurement may be very sensitive to ADC noise, and this requirement may consequently be relatively stringent.

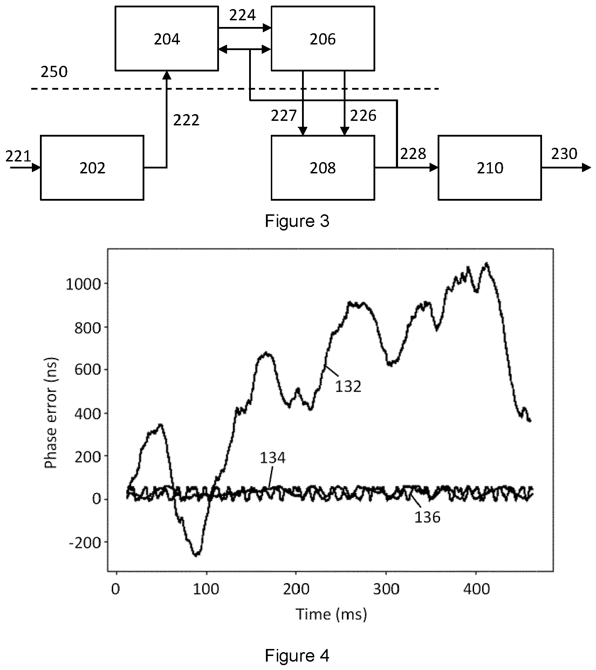

An example implementation for a phase locked loop is shown in Figure 3. The phase locked loop comprises: receiver 202, sync pulse extractor 204, phase locked loop controller 206, digitally controlled oscillator (DCO) 208 and transmitter 210. Line 250 separates digital and analog circuits of the phase locked loop, with digital circuits above the line and analog circuits below the line.

The receiver 202 receives a communications signal 221 from the preceding device in the chain (e.g., the battery pack controller or the preceding battery monitoring circuit). The communications signal 221 includes an embedded clock signal (e.g., is Manchester encoded), and binary data is represented by a rising edge "1" or a falling edge "0", so a low-high signal is a "1", and a high-low signal is a "0". The communications signal may comprise a series of n bit symbols. In the examples used herein, the communications signal comprises 16bit symbols, with a symbol rate of 1MHz, but this is merely illustrative and other data rates and symbol lengths may be used in different embodiments. The receiver 202 may decode the symbols in the incoming communications signal 221 and provide the input signal 222 to the sync pulse extractor 204 (optionally after buffering and/or amplifying the input signal 221).

The sync pulse extractor 204 is configured to extract a sync pulse 224 that is high for one clock cycle (and low the rest of the time) and which has a frequency equal to the symbol rate. The output sync pulse 224 is provided to the phase locked loop controller 206.

The phase locked loop controller 206 receives both the sync pulse 224 and the oscillator signal output 228 by the DCO 208. The phase locked loop controller 206 determines the phase/frequency difference between the sync pulse 224 and the oscillator signal 228, and from this determines at least one digital control signal 227, 226 that is provided to the DCO 208. In this example, the controller 206 may implement a PI control scheme (using a suitable loop filter arrangement) and may provide a coarse digital control signal 227 and a fine digital control signal 226.

The frequency of the DCO 208 is responsive to the digital control signals 227, 226, and the controller 206 and DCO 208 are configured to minimise a phase/frequency error between the sync pulse 224 (obtained from the input communications signal) and the oscillator output 228 (which will form the basis of a clock signal).

The transmitter 210 receives the oscillator signal 228 and is configured to transmit an output communication signal 230 in which the clock is encoded for receipt by the next device in the chain.

The response of the DCO 208 in the PLL of Figure 3 is shown in Figure 4. The line 132 represents the free running oscillator 208, with both white noise and flicker noise. The phase of the free running oscillator 208 is subject to the expected Brownian motion and is subject to significant error. Figure 4 also shows lines for phase error with the PLL active, simulated without 1/f noise 134, and with 1/f noise 136. When the PLL is enabled and the DCO 208 is controlled by the PLL controller 206, the phase is regulated between two distinct levels corresponding with a period of the oscillator 208. Due to the digital control loop, the time resolution is limited to the frequency of the DCO 208. In this example case, the DCO is running at 16MHz, and the symbol rate is 1MHz. A PLL controller that is implemented digitally may be preferable in embodiments that require a low cut-off frequency for the PLL control loop. In addition, the digital synchronisation pulse extraction may be implemented with a relatively simple circuit. It may therefore be desirable to retain phase/frequency error determination and PLL control in the digital domain.

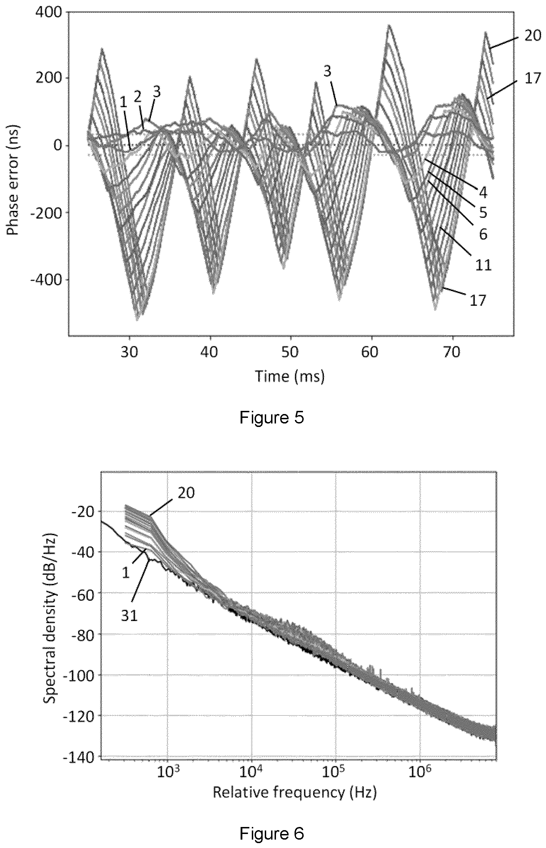

The limited time resolution of the all-digital DCO control arrangement of Figure 3 is potentially problematic when a chain of devices is used, with the PLL of each device locking to the signal from the previous device. Figure 5 illustrates this, showing the build-up of phase error (and eventual oscillation of phase error) through successive devices, with the phase error for the first device denoted by line 1, and the phase error for the nth device denoted by n. Initially the phase error is relatively well controlled, but timing errors build with successive devices in the chain, until large oscillations are seen at device 20 (for example, ~800ns peak to peak variation in phase error). The effect is similar to that of a "phantom traffic jam": the low long-term variations in the DCO frequency (due to flicker noise) cause one oscillator to go slightly faster or slower. The next oscillators try to follow this, but overshoot. This results in significant phase errors.

Figure 6 shows the phase noise of the oscillators in the chain of 20 devices of Figure 5. The phase noise of the free running oscillator 31 is shown, and the phase noise from the first oscillator 1 and last oscillator 20 are labelled. The phase noise at lower frequencies (below 10⁵ Hz) is very high for later oscillators in the chain caused by the large oscillations in the phase of the DCO, which will have an impact on the noise of a battery impedance measurement, which is sensitive to phase noise (as explained above).

To address these shortcomings, while maintaining the generally desirable properties of the digitally implemented sync pulse extractor 204 and phase locked loop controller 206, embodiments employ an analog component in the loop controlling the oscillator to remove time resolution limitations. The additional analog control may be implemented in a way that avoids adding significant phase noise.

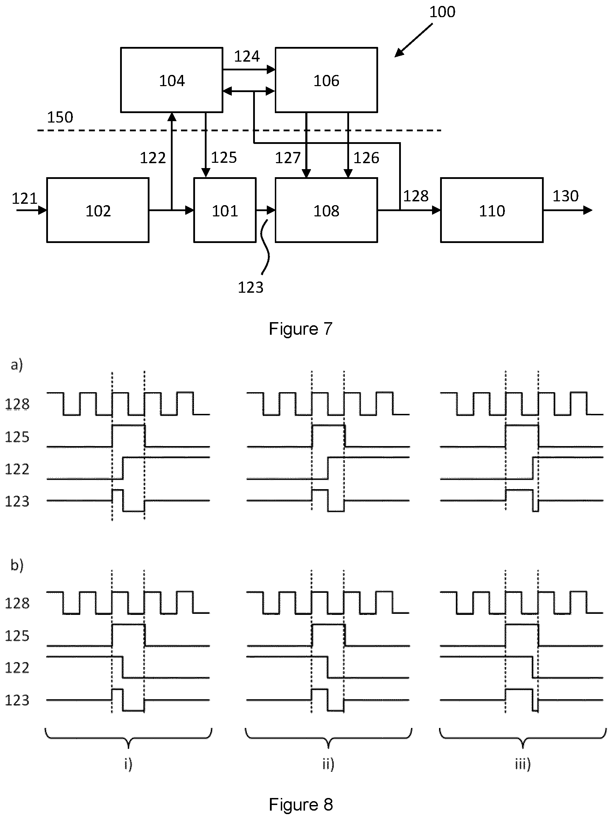

Figure 7 illustrates an example device 100 according to an embodiment, comprising a phase locked loop. The device 100 comprises: receiver 102, sync pulse extractor 104, phase locked loop controller 106, hybrid-controlled oscillator 108 and transmitter 110. Line 150 separates digital and analog circuits of the phase locked loop, with digital circuits above the line and analog circuits below the line. Circuits that handle signals that are quantised in time and amplitude are digital, and circuits that handle signals that are unquantized in at least one of time and amplitude are analog.

The receiver 102, sync pulse extractor 104, phase locked loop controller 106, and phase locked loop controller 106 in this embodiment work in the same way as described with reference to Figure 3. Like features are given like reference numerals, starting with a "1" in Figure 7 instead of a "2" as in Figure 3. The phase locked loop controller 106 remains a digital controller, which provides digital control signals 127, 126 to the hybrid-controlled oscillator 108.

In addition to the digital control signal from the phase locked loop controller 106, a phase pulse controller 101 is provided, configured to provide analog adjustments to the control of the hybrid-controlled oscillator 108. The phase pulse controller 101 thereby improves the resolution with which the phase locked loop tracks the phase of the input signal, so that serially connected chains of phase locked loops can be implemented without build-up of phase error and the sort of instability shown in Figures 5 and 6. In an example embodiment, the phase pulse controller 101 is analog in the time domain, and outputs pulses (which may be quantised in amplitude) that are unquantized in the time domain (i.e. asynchronous with the clock).

In addition to extracting the sync pulse 124 (as described with reference to Figure 3), the sync pulse extractor 104 in this embodiment is also configured to produce a phase pulse enable signal 125 that is synchronised with the oscillator signal from 128 the oscillator 108. The phase pulse enable signal 125 is a pulse with a duration equal to one cycle of the oscillator 108. In this example embodiment, the phase pulse enable signal 125 is produced with a frequency equal to the symbol rate (of 1MHz), but in principle, the frequency may be the oscillator frequency divided by any integer (including 1).

The phase pulse controller 101 receives the input signal 122 from the receiver 102 and the phase pulse enable signal 125. The phase pulse controller 101 outputs current only when the phase pulse enable signal 125 is active (in this example, "1" or "high" is active). When the phase pulse enable 125 signal is active, the phase pulse controller 101 outputs a positive charging current until an edge is detected in the input signal 122, when the phase pulse controller 101 toggles to outputting a negative charging current. The timing of the toggling of the phase pulse controller 101 is analog (so is not quantised to the clock rate).

In this example embodiment, the input signal 122 is Manchester encoded so that the edge of the input signal 122 should be in the centre of "on" duration of the phase pulse enable signal 125, which corresponds with a clock period of the oscillator 108.

Figure 8 illustrates the operation of the phase pulse controller 101 with some example signals. In Figure 8 a) the receiver output 122 is "1" during the period that the phase pulse enable signal 125 is active (there is a rising edge in the receiver output 122) and in Figure b) the receiver output 122 is "0" during the period that the phase pulse enable signal 125 is active (there is a falling edge in the receiver output 122). Timing situations are shown corresponding with: i) the oscillator signal 128 lagging behind the receiver output 122, ii) the oscillator signal 128 synchronised with the receiver output 122, and iii) the oscillator signal 128 leading the receiver output 122. The phase control signal 123 output from the phase pulse controller 101 is illustrated for each case.

In situations where the oscillator signal 128 leads the receiver output 122, the integral of the phase control signal 123 over the duration of the phase pulse enable signal 125 is negative. In situations where the oscillator signal 128 lags the receiver output 122, the integral of the phase control signal 123 over the duration of the phase pulse enable signal 125 is positive. The magnitude of the integral of the phase control signal 123 over each period of the phase pulse enable signal 125 is proportional to the timing/phase error between the oscillator signal 128 and the receiver output 122 (which is the input signal to the sync pulse extractor 104). The phase control output 123 is therefore an analog control signal, which is provided to the hybrid-controlled oscillator 108 in order to adjust the oscillator rate to reduce phase error. The phase control signal 123 is added to a charging current in the oscillator core. An increment in charging current will result in faster charging and discharging times, resulting in an increase in output frequency, and a decrement in charging current will result in slower charging and discharging times, resulting in a decrease in output frequency (thereby reducing the phase error).

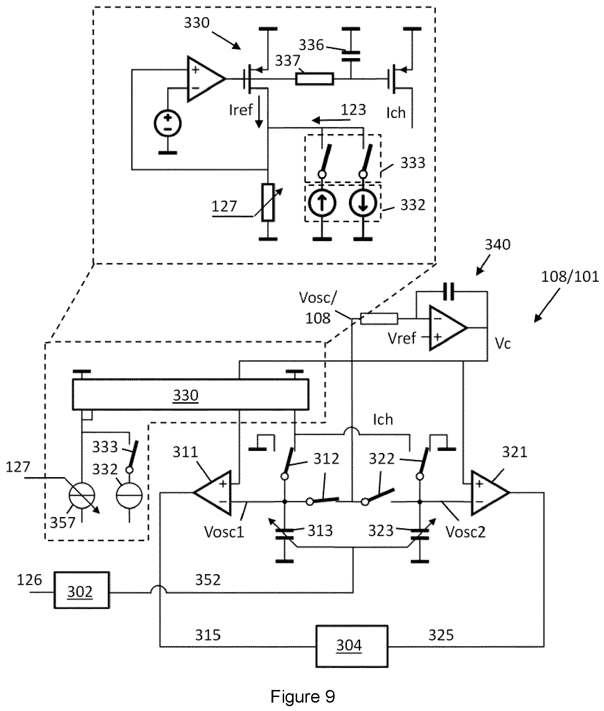

Figure 9 outlines an example topology for an oscillator design and phase pulse control implementation. The oscillator 108 in this example is a relaxation oscillator, comprising: first and second core capacitors 313, 323, first and second switching systems 312, 322, first and second comparators 311, 321, and switching controller 304.

In a first state (shown) of the first and second switching systems 312, 322: the first core capacitor 313 is connected to receive an input charging current Ich and to the oscillator output Vosc/108; and the second core capacitor 323 is connected to ground (to discharge) and not connected to the oscillator output 108. In a second state (not shown) of the first and second switching systems 312, 322: the second core capacitor 323 is connected to receive the input charging current Ich and to the oscillator output Vosc/108, and the first core capacitor 313 is connected to ground (to discharge) and not connected to the oscillator output 108.

The switching controller 304 toggles the state of the switches of the first and second switching systems 312, 322 in response to an output from the first or second comparator 311, 321 indicating the voltage at the first or second core capacitor 311, 321 has exceeded the control voltage Vc. Each time the switching controller 304 switches the state of the oscillator, the oscillator output voltage 108/Vosc is reset to zero and will subsequently increase at a rate determined by the charging current and the size of the core capacitor receiving the charge. The frequency of the oscillator 108 can therefore be adjusted by varying the charging current or the core capacitance.

The control voltage Vc is determined by a voltage averaging filter 340. This is optional, but may be advantageous for a low power, low noise oscillator that is insensitive (e.g., to changes in temperature).

The frequency of the oscillator 108 is controlled by a first and second digital control input 126, 127. The first digital control input 126 controls the capacitance of the core capacitors, and the second digital control input 127 controls the charging current. In some embodiments, the second digital control input may provide for more coarse adjustment of frequency than the first digital control input (i.e. the first control input 126 may provide for fine adjustment, while the second control input 127 may provide for coarse adjustment).

The first and second core capacitors 311, 321 may each comprise a variable capacitance, responsive to the first digital control input 126 and may comprise a binary weighted switched capacitor network and/or one or more varactors, for example. A low pass filter 302 may be provided between the first digital control input 126 and the first and second core capacitors 311, 323. In an example, the first digital control input 126 may comprise a sigma-delta bitstream, which is filtered by an analog filter and provided as a control voltage to a varactor, but other arrangements may be used.

The second digital control input 127 controls the charging current Ich by adjusting the amount of current provided by current source 357. The current provided by current source 357 is summed with the current of the phase control signal 123.

The phase control signal 123 is produced by a switchable current source 332, which produces negative or positive current, as already described above with reference to Figure 8. The sum of the current from the phase control signal 123 and the current from current source 357 is Iref. This current Iref is mirrored (and optionally amplified) by a low pass filtering current mirror 330 to provide the charging current Ich, which is provided to the first and second core capacitors 313, 323. The low pass filtering is implemented by an RC network comprising capacitor 336 and resistor 337 (but other arrangements may be used).

Low pass filtering the charging current in this way reduces the jitter that may otherwise result from the phase control signal. The changes in the charging current are smoothed out over time, reducing jitter. The effectiveness of the phase control signal is not reduced - just spread out over a longer time. In some embodiments, the cut-off frequency for the low pass filter may be lower than the clock frequency (e.g., at least 5, or 10 or 20 times lower). In some embodiments the cut-off frequency for the low pass filter may be lower than the symbol rate (for example at least 2 or 3 or 5 times lower). The cut-off frequency may be less than 500kHz, less than 400kHz, less than 300kHz or less than 200kHz. The cut-off frequency may be at least 0.05 times the symbol rate, or at least 0.1 times the symbol rate.

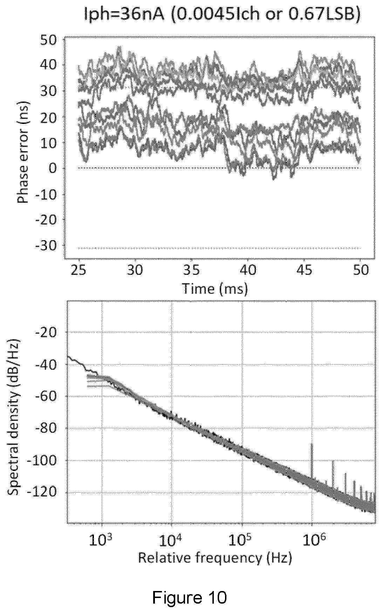

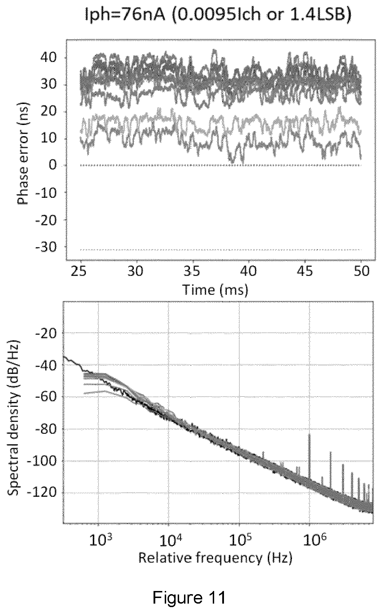

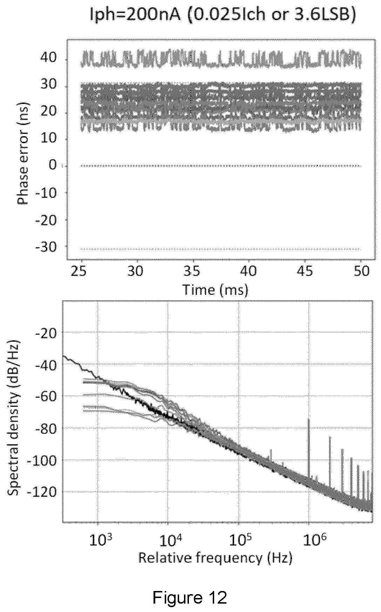

Figures 10, 11 and 12 show results for phase error (with respect to time) and phase noise (spectral density) obtained from an example phase locked loop like that of Figure 9 for different phase control signal currents (corresponding with currents of 0.67, 1.4 and 3.6 of the current increment of a least significant bit of the digitally controlled current source 357). The results are shown for a daisy chain of 10 PLL modules. No oscillations in the phase error are seen, and the phase error is well controlled in each oscillator (including those at the end of the chain). Higher phase control signal currents result in increased phase stability. However, the phase control signal produces some phase noise, particularly at the frequency of the phase control signal (which is controlled by the phase pulse enable signal). In this example the phase control signal has a frequency of 1 MHz, and a peak in phase noise can clearly be seen at this frequency and harmonics thereof. The phase noise introduced by the phase control signal increases with higher phase control signal currents.

This situation can be improved by introducing pseudo-randomness to the phase control signal. Instead of enabling the phase control signal 123 at each phase pulse enable signal 125, the phase pulse controller 101 may be configured to respond or not respond in a pseudorandom way to each cycle of the phase pulse enable signal 125. This can easily be implemented by using a linear feedback shift register block in the phase pulse controller 101 (for example). In an alternative, the sync pulse detector 104 may be configured to produce the phase pulse enable signal 125 or not to produce the phase pulse enable signal 125 in a similar pseudorandom manner at each cycle.

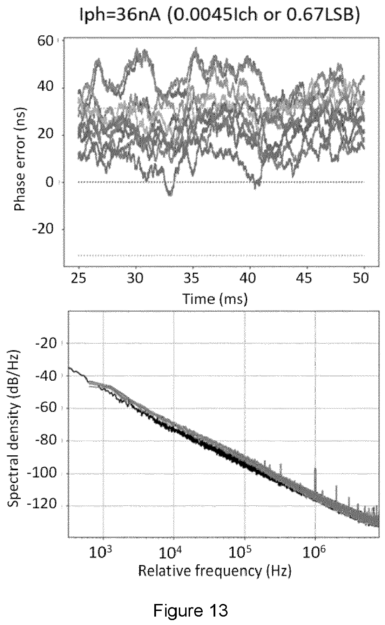

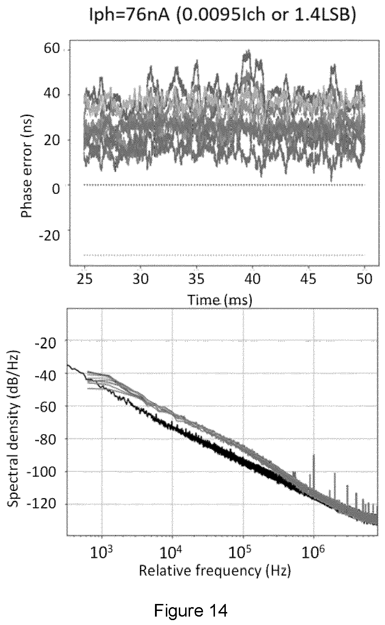

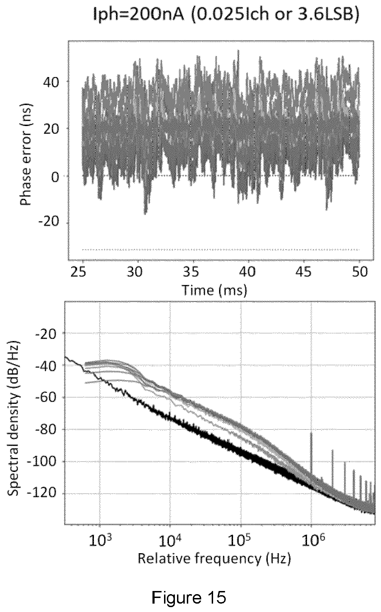

Randomness in enabling the phase pulse controller 101 will help shape noise introduced by the phase control signal and to reduce the peak phase noise at higher frequencies. The effect of this approach is shown in Figures 13, 14 and 15. These graphs show data obtained under the same conditions as Figures 10, 11 and 12, but in which the phase pulse controller 101 is pseudo-randomly enabled (for example, so that it has a 50% chance of being enabled or not enabled for each phase pulse enable period).

Figures 13 to 15 show there is a clear benefit to using pseudorandom control. The amplitude of the spikes in the phase noise spectrum are reduced for a similar stability of the oscillator. However, the phase noise is increased somewhat at the lower relative frequencies. Depending on the requirements of the system, the low frequency phase noise may be less of a problem than the spikes at higher frequencies. Even at high phase control signal currents, the impact on the phase noise on a battery monitoring ADC may be significantly lower than for a fixed scheme in which there is no pseudo-randomness.

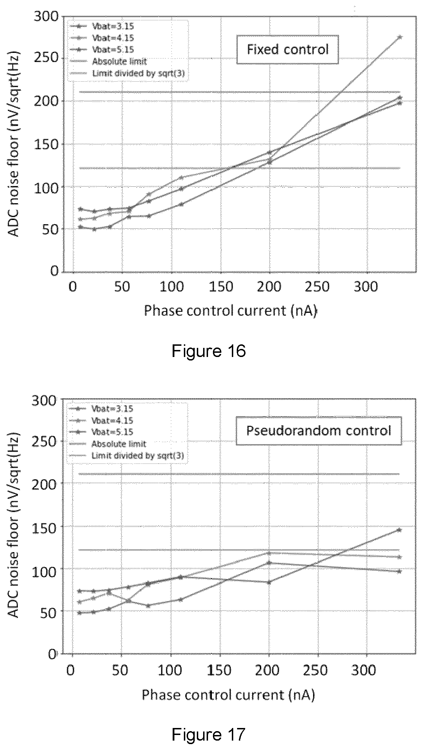

The impact of this pseudorandom control in the specific example case of an ADC for measurement of battery impedance is shown in Figures 16 and 17. The ADC noise is affected more by phase noise at higher frequencies, so the impact of the pseudorandom control is significant. Figure 16 plots an ADC noise floor against a phase control signal current for a fixed (not random) control arrangement, and Figure 17 plots the same parameters when the phase pulse is under pseudorandom control. The pseudorandom control keeps the noise floor of the ADC low, even for high phase control signal currents.

From reading the present disclosure, other variations and modifications will be apparent to the skilled person. Such variations and modifications may involve equivalent and other features which are already known in the art of memory systems, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness, it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A phase locked loop, comprising:
a hybrid-controlled oscillator, comprising a digital control input and a phase pulse control input, wherein a frequency of oscillation of an oscillator signal from the oscillator is responsive to both the digital control input and the phase pulse control input;
a sync pulse detector configured to receive a digital input signal and to output a sync pulse signal that is synchronised to the input signal and a phase pulse enable signal that is synchronised with the oscillator signal;
a phase locked loop controller configured to receive the sync pulse signal and the oscillator signal, and to provide a digital control signal at the digital control input of the hybrid-controlled oscillator responsive to an error between the sync pulse signal and the oscillator signal;
a phase pulse controller, configured to receive the phase pulse enable signal and the input signal, and to output an analog phase control signal to the hybrid-controlled oscillator corresponding with a timing error between the phase pulse enable signal and the input signal.

2. The phase locked loop of claim 1, wherein the phase pulse controller is configured to generate a phase control signal that:
i) is enabled by the phase pulse enable signal; and
ii) switches state in response to an edge of the input signal.

3. The phase locked loop of claim 2, wherein the phase pulse controller is configured to produce a phase control signal that:
i) comprises a positive current when the phase control signal is enabled and in a first state, and
ii) comprises a negative current when the phase control signal is enabled and in a second state.

4. The phase locked loop of claim 3, comprising a low pass filter configured to filter the phase control signal.

5. The phase locked loop of claim 4, wherein the hybrid-controlled oscillator comprises a digitally controlled current source that is responsive to the digital control input, wherein the low pass filter filters the sum of the output current from the digitally controlled current source and the phase control signal.

6. The phase locked loop of any preceding claim, wherein the sync pulse detector further comprises a randomiser, configured to pseudo-randomly enable or disable the phase pulse enable signal, thereby shaping phase noise in the oscillator signal.

7. The phase locked loop of any preceding claim, wherein the sync pulse detector is configured to produce a periodic phase pulse enable signal that is in a first state for one clock period of the input signal.

8. The phase locked loop of any preceding claim, wherein the sync pulse detector is configured to produce a phase pulse enable signal with a frequency corresponding with a symbol rate of the input signal.

9. The phase locked loop of any preceding claim, wherein the hybrid controller oscillator comprises a relaxation oscillator configured to switch between charging and discharging one or more core capacitors to generate the oscillator signal.

10. A plurality of devices, each device comprising a phase locked loop according to any preceding claim 1 to 9, wherein the devices are connected in series, and in which the phase locked loop of each device subsequent to a first device is configured to synchronise with an output signal from a preceding device.

11. A battery monitoring circuit, comprising a phase locked loop according to any of claims 1 to 9.

12. The plurality of devices of claim 10, wherein each device is a battery monitoring circuit.

13. The battery monitoring circuit of claim 11, further comprising a cell impedance test circuit configured to test a cell impedance of one or more associated cells, wherein the battery controller is configured to perform the cell impedance test synchronously with the input signal; or
the plurality of battery monitoring circuits of claim 12, wherein each battery monitoring circuit comprises a cell impedance test circuit configured to test a cell impedance of one or more associated cells, wherein each battery monitoring circuit is configured to perform the cell impedance test synchronously with its input signal.

14. A method of synchronising a device to a digital input signal, comprising:
producing a phase pulse enable signal that is synchronised with an oscillator of the device,
producing an analog phase control signal corresponding with a timing error between the phase pulse enable signal and the input signal.

15. The method of claim 14, wherein the phase control signal:
i) is enabled by the phase pulse enable signal; and
ii) switches state in response to an edge of the input signal.
